# EUROPEAN PATENT APPLICATION

(11) **EP 4 641 627 A2**
(43) Date of publication of application: **29.10.2025**
(21) Application number: 25171173.5
(22) Date of filing: 17.04.2025
(51) Int. Cl.: H01L 21/67

(54) **CLEANING METHOD AND CLEANING APPARATUS FOR WAFER**

(30) Priority: 23.04.2024 JP 2024069864
(71) Applicant: EBARA CORPORATION, Ota-ku, Tokyo 144-8510 (JP)
(72) Inventor: MARUYAMA, Koji, Tokyo 1448510 (JP); KAJITA, Shinji, Tokyo 1448510 (JP)
(74) Representative: Schmidbauer, Andreas Konrad

(57) **Abstract**

A cleaning method which can obtain highly reproducible cleaning efficiency by forcibly controlling a shape of a wafer using roll cleaning members. The scrub cleaning operation for a wafer includes: a reference cleaning operation of scrubbing the first surface and the second surface of the wafer with the first roll cleaning member and the second roll cleaning member located at a reference cleaning position; a first offset cleaning operation of scrubbing the first surface and the second surface of the wafer with the first roll cleaning member and the second roll cleaning member located at a first offset cleaning position shifted from the reference cleaning position in a direction toward the first roll cleaning member; and a second offset cleaning operation of scrubbing the first surface and the second surface of the wafer with the first roll cleaning member and the second roll cleaning member located at a second offset cleaning position shifted from the reference cleaning position in a direction toward the second roll cleaning member.

## Description

### BACKGROUND OF THE INVENTION

### Field of the Invention:

The present invention relates to a method and an apparatus for cleaning a wafer, and more particularly to a method and an apparatus for scrubbing both surfaces of a wafer having a multilayered interconnect structure.

### Description of the Related Art:

In recent years, with a progress of high integration of semiconductor devices, interconnects of a circuit are becoming finer and a distance between the interconnects is becoming narrower. In manufacturing of semiconductor devices, many types of materials are repeatedly formed into films on a wafer to form a multilayered structure. In order to form the multilayered structure, it is important to planarize a surface of the wafer. A polishing apparatus (which may be referred to chemical-mechanical polishing apparatus) that performs chemical mechanical polishing (CMP) is used as a technique of planarizing the surface of the wafer.

The chemical-mechanical polishing (CMP) apparatus generally includes a polishing table on which a polishing pad is attached, a polishing head for pressing a wafer against the polishing pad on the polishing table, and a nozzle for supplying a polishing liquid onto the polishing pad. While the polishing liquid is supplied onto the polishing pad from the nozzle, the polishing head presses the wafer against the polishing pad. The polishing head and the polishing pad are moved relative to each other, thereby polishing the wafer.

After CMP, the polishing liquid, debris generated in the polishing process, etc. remain on a front surface, a back surface, and a side surface (bevel portion) of the wafer. In the manufacturing process of semiconductor wafers, a cleanliness of a device-forming surface is important. Therefore, the polished wafer is transported from the polishing apparatus to a cleaning apparatus, where the wafer is cleaned. The cleaning apparatus scrubs both sides of the wafer with roll cleaning members while supplying a cleaning liquid to both sides of the wafer.

### Citation List

### Patent Literature

Patent document 1: Japanese laid-open patent publication No. 2023-45821

In recent years, there is a trend in wafers to have multi-layered and three-dimensional structures. A wafer having such structures may be warped. When the wafer is warped, the roll cleaning member cannot properly contact the wafer surface, and cannot efficiently remove the deposits from the wafer. Depending on the type of wafer and the wafer manufacturing process, the wafer may be warped in a convex shape or a concave shape. Present cleaning apparatuses are configured to clean wafers with different warped shapes according to the same cleaning recipe. As a result, it is difficult to ensure cleaning efficiency for all wafers with different warped shapes.

### SUMMARY OF THE INVENTION

An object of the present invention is to provide a cleaning method and a cleaning apparatus which can obtain highly reproducible cleaning efficiency by forcibly controlling a shape of a wafer using roll cleaning members, regardless of the shape of the wafer.

In an embodiment, there is provided a cleaning method of cleaning a wafer, comprising: performing a scrub cleaning operation of scrubbing a first surface and a second surface of the wafer with a first roll cleaning member and a second roll cleaning member, respectively, while rotating the wafer about a central axis with a plurality of holding rollers contacting a periphery of the wafer, the scrub cleaning operation including: a reference cleaning operation of scrubbing the first surface and the second surface of the wafer with the first roll cleaning member and the second roll cleaning member located at a reference cleaning position; a first offset cleaning operation of scrubbing the first surface and the second surface of the wafer with the first roll cleaning member and the second roll cleaning member located at a first offset cleaning position shifted from the reference cleaning position in a direction toward the first roll cleaning member; and a second offset cleaning operation of scrubbing the first surface and the second surface of the wafer with the first roll cleaning member and the second roll cleaning member located at a second offset cleaning position shifted from the reference cleaning position in a direction toward the second roll cleaning member.

In an embodiment, the reference cleaning operation, the first offset cleaning operation, and the second offset cleaning operation are performed in a predetermined order.

In an embodiment, the scrub cleaning operation further includes a first intermediate offset cleaning operation of scrubbing the first surface and the second surface of the wafer with the first roll cleaning member and the second roll cleaning member located at a first intermediate offset position, and the first intermediate offset position is located between the reference cleaning position and the first offset cleaning position.

In an embodiment, the scrub cleaning operation further includes a second intermediate offset cleaning operation of scrubbing the first surface and the second surface of the wafer with the first roll cleaning member and the second roll cleaning member located at a second intermediate offset position, and the second intermediate offset position is located between the reference cleaning position and the second offset cleaning position.

In an embodiment, there is provided a cleaning apparatus for cleaning a wafer, comprising: a plurality of holding rollers which are rotatable and are configured to contact a periphery of the wafer and rotate the wafer about a central axis; a first roll cleaning member and a second roll cleaning member configured to scrub a first surface and a second surface of the wafer, respectively; a first actuator coupled to the first roll cleaning member and configured to move the first roll cleaning member; a second actuator coupled to the second roll cleaning member and configured to move the second roll cleaning member; and an operation controller configured to control operations of the first actuator and the second actuator, wherein the operation controller is configured to instruct the first actuator and the second actuator to move the first roll cleaning member and the second roll cleaning member to a reference cleaning position, a first offset cleaning position, and a second offset cleaning position, the cleaning apparatus is configured to perform a scrub cleaning operation including a combination of: a reference cleaning operation of scrubbing the first surface and the second surface of the wafer with the first roll cleaning member and the second roll cleaning member located at the reference cleaning position; a first offset cleaning operation of scrubbing the first surface and the second surface of the wafer with the first roll cleaning member and the second roll cleaning member located at the first offset cleaning position shifted from the reference cleaning position in a direction toward the first roll cleaning member; and a second offset cleaning operation of scrubbing the first surface and the second surface of the wafer with the first roll cleaning member and the second roll cleaning member located at the second offset cleaning position shifted from the reference cleaning position in a direction toward the second roll cleaning member.

In an embodiment, the operation controller is configured to instruct the first actuator and the second actuator to move the first roll cleaning member and the second roll cleaning member to the reference cleaning position, the first offset cleaning position, and the second offset cleaning position in a predetermined order.

In an embodiment, the operation controller is configured to instruct the first actuator and the second actuator to move the first roll cleaning member and the second roll cleaning member to a first intermediate offset position located between the reference cleaning position and the first offset cleaning position, and the cleaning apparatus is further configured to perform a first intermediate offset cleaning operation of scrubbing the first surface and the second surface of the wafer with the first roll cleaning member and the second roll cleaning member located at the first intermediate offset position.

In an embodiment, the operation controller is configured to instruct the first actuator and the second actuator to move the first roll cleaning member and the second roll cleaning member to a second intermediate offset position located between the reference cleaning position and the second offset cleaning position, and the cleaning apparatus is further configured to perform a second intermediate offset cleaning operation of scrubbing the first surface and the second surface of the wafer with the first roll cleaning member and the second roll cleaning member located at the second intermediate offset position.

The first roll cleaning member and the second roll cleaning member move among the reference cleaning position, the first offset cleaning position, and the second offset cleaning position to force the wafer to deform in the first direction and the second direction which are symmetrical with respect to the reference cleaning position during cleaning of the wafer. The pressure distribution applied to the wafer by the first roll cleaning member and the second roll cleaning member changes during cleaning of the wafer. As a result, wafers of any shape can be cleaned with the same cleaning efficiency.

### BRIEF DESCRIPTION OF THE DRAWINGS

FIG. 1 is a perspective view illustrating an embodiment of a cleaning apparatus for cleaning a wafer;
FIG. 2 is a diagram showing an embodiment of a detailed configuration of the cleaning apparatus shown in FIG. 1;
FIG. 3 is a diagram for explaining an operation of cleaning a wafer;
FIG. 4 is a diagram illustrating a reference cleaning position of a first roll cleaning member and a second roll cleaning member;
FIG. 5 is a diagram illustrating a first offset cleaning position of the first roll cleaning member and the second roll cleaning member;
FIG. 6 is a diagram illustrating a second offset cleaning position of the first roll cleaning member and the second roll cleaning member;
FIG. 7 is a schematic diagram illustrating an embodiment of a scrub cleaning operation for cleaning a flat-shaped wafer;
FIG. 8 is a schematic diagram showing an embodiment of a scrub cleaning operation for cleaning a wafer having a convex first surface;
FIG. 9 is a schematic diagram illustrating an embodiment of a scrub cleaning operation for cleaning a wafer having a concave first surface;
FIG. 10 is a diagram showing a distribution of pressure applied to a wafer from the first roll cleaning member and the second roll cleaning member during a first offset cleaning operation;
FIG. 11 is a diagram showing a distribution of pressure applied to a wafer from the first roll cleaning member and the second roll cleaning member during a second offset cleaning operation;
FIG. 12 is a diagram showing an embodiment of a first intermediate offset position between the reference cleaning position and the first offset cleaning position;
FIG. 13 is a diagram showing an embodiment of a second intermediate offset position between the reference cleaning position and the second offset cleaning position; and
FIG. 14 is a perspective view showing another embodiment of the cleaning apparatus.

### DESCRIPTION OF EMBODIMENTS

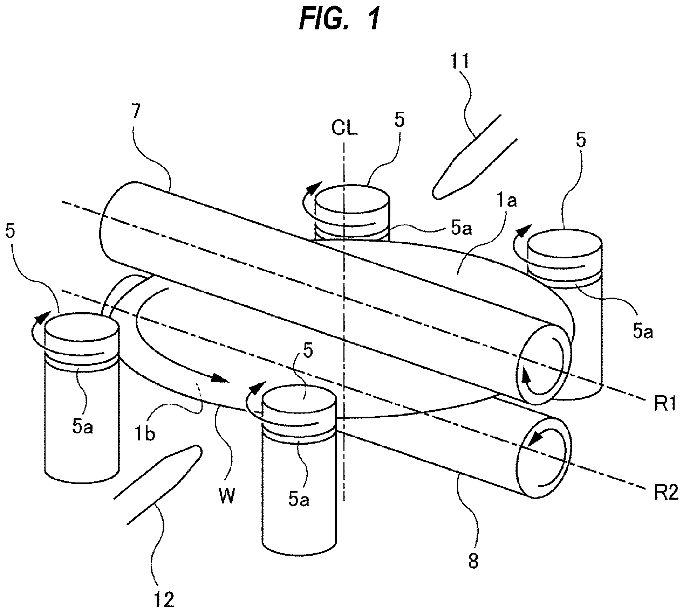

Hereinafter, embodiments of the present invention will be described with reference to the drawings. FIG. 1 is a perspective view showing an embodiment of a cleaning apparatus for cleaning a wafer. As shown in FIG. 1, the cleaning apparatus includes a plurality of rotatable holding rollers 5 configured to contact a periphery of a wafer W and rotate the wafer W about a central axis CL, and a first roll cleaning member 7 and a second roll cleaning member 8 configured to scrub and clean a first surface 1a and a second surface 1b of the wafer W.

The first surface 1a and the second surface 1b of the wafer W are circular surfaces. The first surface 1a of the wafer W is, for example, a device surface on which devices are formed or to be formed. The second surface 1b of the wafer W is, for example, a non-device surface on which devices are not formed or not to be formed. The second surface 1b is located at the opposite side from the first surface 1a.

The plurality of holding rollers 5 are arranged around the central axis CL. The plurality of holding rollers 5 when holding the wafer W are at the same distance from the central axis CL. The center of the wafer W held by the plurality of holding rollers 5 is on the central axis CL. In this embodiment, four holding rollers 5 are arranged, while five or more holding rollers 5 may be arranged. The plurality of holding rollers 5 are coupled to a roller rotating device (not shown), so that the plurality of holding rollers 5 are rotated in the same direction at the same rotation speed by the roller rotating device as shown in FIG. 1. Each holding roller 5 has a wafer holding groove 5a formed on its outer circumferential surface. The wafer holding groove 5a is an annular groove extending in a circumferential direction of the outer circumferential surface of each holding roller 5. A width of the wafer holding groove 5a is larger than a thickness of the wafer W, and the periphery of the wafer W contacts the wafer holding grooves 5a of the plurality of holding rollers 5. These wafer holding grooves 5a can stabilize a posture of the rotating wafer W.

Each of the first roll cleaning member 7 and the second roll cleaning member 8 has a cylindrical shape. The first roll cleaning member 7 and the second roll cleaning member 8 are coupled to a first rotating device and a second rotating device (which will be described later), respectively. The first rotating device and the second rotating device are configured to rotate the first roll cleaning member 7 and the second roll cleaning member 8 about their own axes. Each of the first roll cleaning member 7 and the second roll cleaning member 8 is made of an elastic material, such as sponge. The first roll cleaning member 7 and the second roll cleaning member 8 rotate and come into sliding contact with the first surface 1a and the second surface 1b of the wafer W, thereby scrubbing and cleaning the first surface 1a and the second surface 1b.

During cleaning of the wafer W, the first roll cleaning member 7 contacts the center of the first surface 1a of the wafer W, and the second roll cleaning member 8 contacts the center of the second surface 1b of the wafer W. In one embodiment, a central axis R1 of the first roll cleaning member 7 passes through the central axis CL, and a central axis R2 of the second roll cleaning member 8 also passes through the central axis CL. An axial length of each of the first roll cleaning member 7 and the second roll cleaning member 8 is equal to or greater than a diameter of the wafer W. In one embodiment, both ends of each of the first roll cleaning member 7 and the second roll cleaning member 8 protrude from the wafer W, as shown in FIG. 1. The first roll cleaning member 7 and the second roll cleaning member 8 can contact the entire first surface 1a and the entire second surface 1b of the wafer W.

The cleaning apparatus includes a first cleaning-liquid nozzle 11 adjacent to the first roll cleaning member 7 and a second cleaning-liquid nozzle 12 adjacent to the second roll cleaning member 8. The first cleaning-liquid nozzle 11 supplies cleaning liquid onto the first surface 1a of the wafer W held and rotated by the plurality of holding rollers 5, and the second cleaning-liquid nozzle 12 supplies cleaning liquid onto the second surface 1b of the wafer W held and rotated by the plurality of holding rollers 5. The first roll cleaning member 7 and the second roll cleaning member 8 scrub the first surface 1a and the second surface 1b of the wafer W in the presence of the cleaning liquid. Examples of the cleaning liquid include a chemical liquid, pure water, and a combination thereof.

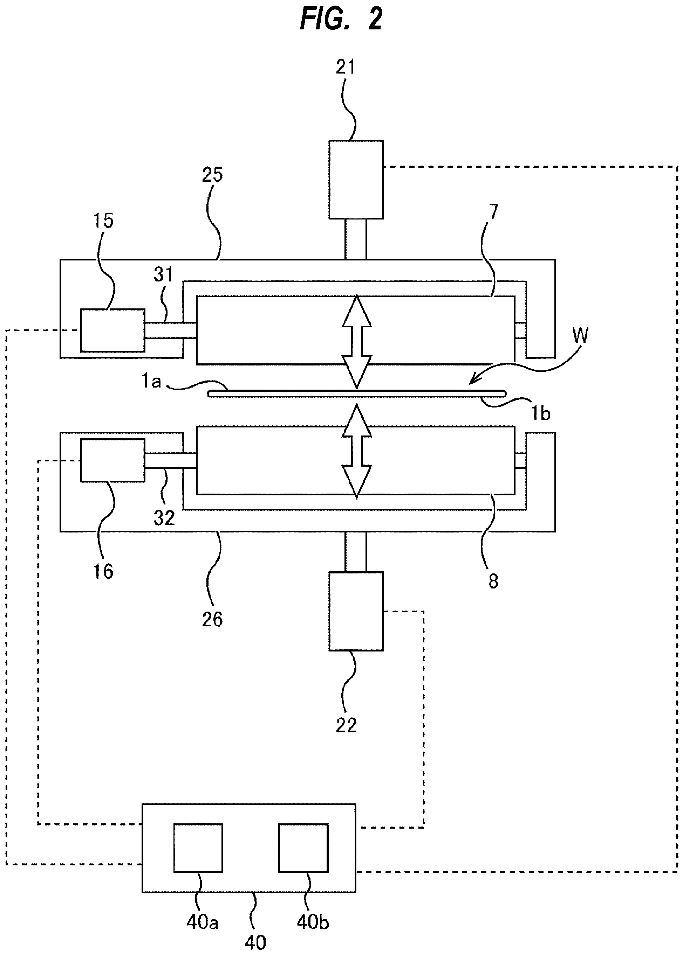

FIG. 2 is a diagram showing an embodiment of a detailed configuration of the cleaning apparatus shown in FIG. 1. As shown in FIG. 2, the cleaning apparatus includes a first rotating device 15 configured to rotate the first roll cleaning member 7 about its axis, a second rotating device 16 configured to rotate the second roll cleaning member 8 about its axis, a first actuator 21 configured to move the first roll cleaning member 7, a second actuator 22 configured to move the second roll cleaning member 8, a first support base 25 that rotatably supports the first roll cleaning member 7, and a second support base 26 that rotatably supports the second roll cleaning member 8.

The first rotating device 15 is fixed to the first support base 25, and the second rotating device 16 is fixed to the second support base 26. The first rotating device 15 is coupled to the first roll cleaning member 7 via a first rotation shaft 31, and the second rotating device 16 is coupled to the second roll cleaning member 8 via a second rotation shaft 32. Specific configurations of the first rotating device 15 and the second rotating device 16 are not particularly limited. Examples of the first rotating device 15 and the second rotating device 16 include an electric motor, and a combination of an electric motor and a torque transmission mechanism (e.g., a belt or gears).

The first actuator 21 is coupled to the first roll cleaning member 7 via the first support base 25, and the second actuator 22 is coupled to the second roll cleaning member 8 via the second support base 26. More specifically, the first actuator 21 is coupled to the first support base 25 that rotatably supports the first roll cleaning member 7, and the second actuator 22 is coupled to the second support base 26 that rotatably supports the second roll cleaning member 8.

The first actuator 21 is configured to move the first roll cleaning member 7, the first support base 25, and the first rotating device 15 together toward and away from the first surface 1a of the wafer W. The second actuator 22 is configured to move the second roll cleaning member 8, the second support base 26, and the second rotating device 16 together toward and away from the second surface 1b of the wafer W.

Specific configuration of the first actuator 21 and the second actuator 22 is not particularly limited. Examples of the first actuator 21 and the second actuator 22 include a combination of an air cylinder and a pressure regulator, and a combination of a ball screw mechanism and a servo motor.

The cleaning apparatus includes an operation controller 40 configured to control operations of the roller rotating device (not shown), the first rotating device 15, the second rotating device 16, the first actuator 21, and the second actuator 22. The roller rotating device (not shown), the first rotating device 15, the second rotating device 16, the first actuator 21, and the second actuator 22 are electrically coupled to the operation controller 40.

The operation controller 40 includes a memory 40a storing a program therein, and an arithmetic device 40b configured to execute arithmetic operations according to instructions included in the program. The operation controller 40 is composed of at least one computer. The memory 40a includes a main memory, such as a random access memory (RAM), and an auxiliary memory, such as a hard disk drive (HDD) or a solid state drive (SSD). Examples of the arithmetic device 40b include a CPU (Central Processing Unit) and a GPU (Graphics Processing Unit). However, the specific configuration of the operation controller 40 is not limited to these examples.

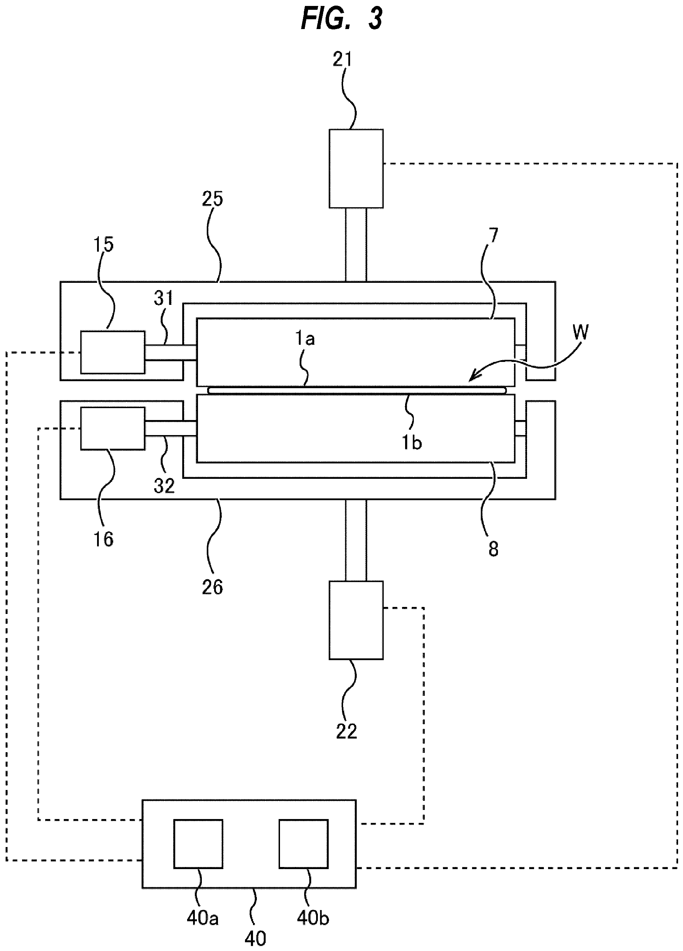

The wafer W is cleaned as follows. The wafer W is held by the plurality of holding rollers 5. Then, while the cleaning liquid is supplied from the first cleaning-liquid nozzle 11 and the second cleaning-liquid nozzle 12 onto the first surface 1a and the second surface 1b of the wafer W, the wafer W is rotated by the plurality of holding rollers 5. The first rotating device 15 and the second rotating device 16 rotate the first roll cleaning member 7 and the second roll cleaning member 8, respectively. When the rotation speed of the wafer W reaches a predetermined rotation speed, the first actuator 21 and the second actuator 22 bring the first roll cleaning member 7 and the second roll cleaning member 8 into contact with the first surface 1a and the second surface 1b of the rotating wafer W, respectively, as shown in FIG. 3. The rotating first roll cleaning member 7 and the rotating second roll cleaning member 8 scrub and clean the first surface 1a and the second surface 1b by rubbing the first surface 1a and the second surface 1b of the wafer W in the presence of the cleaning liquid.

The operation controller 40 is configured to instruct the first actuator 21 and the second actuator 22 to move the first roll cleaning member 7 and the second roll cleaning member 8 to a reference cleaning position, a first offset cleaning position, and a second offset cleaning position in a predetermined sequence while the wafer W is being cleaned.

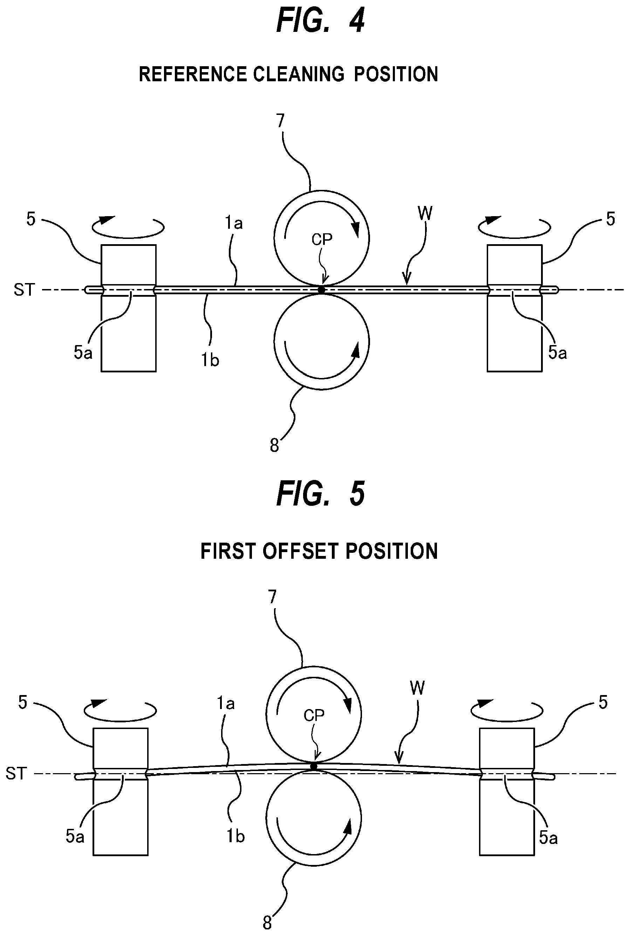

FIG. 4 is a diagram for explaining the reference cleaning position of the first roll cleaning member 7 and the second roll cleaning member 8. The reference cleaning position is a position where the central point CP of the wafer W is present in a plane (imaginary plane) ST passing through the plurality of wafer holding grooves 5a of the plurality of holding rollers 5. When the wafer W is sandwiched between the first roll cleaning member 7 and the second roll cleaning member 8 at the reference cleaning position, the wafer W is held in a flat shape as shown in FIG. 4. In this specification, scrubbing the wafer W with the first roll cleaning member 7 and the second roll cleaning member 8 at the reference cleaning position is defined as reference cleaning operation.

FIG. 5 is a diagram illustrating a first offset cleaning position of the first roll cleaning member 7 and the second roll cleaning member 8. The first offset cleaning position is a position shifted from the reference cleaning position shown in FIG. 4 in a direction toward the first roll cleaning member 7. The central point CP of the wafer W is away from the plane ST and is located between the first roll cleaning member 7 and the plane ST. When the wafer W is sandwiched between the first roll cleaning member 7 and the second roll cleaning member 8 at the first offset cleaning position as shown in FIG. 5, the first surface 1a of the wafer W is held in a convex shape, and the second surface 1b of the wafer W is held in a concave shape. In this specification, scrubbing the wafer W with the first roll cleaning member 7 and the second roll cleaning member 8 at the first offset cleaning position is defined as first offset cleaning operation.

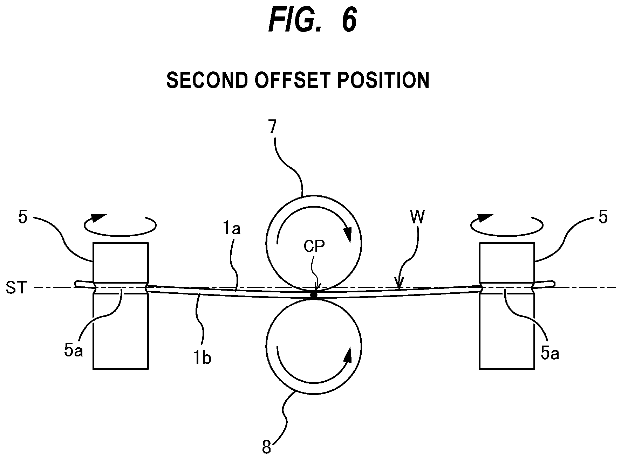

FIG. 6 is a diagram for explaining a second offset cleaning position of the first roll cleaning member 7 and the second roll cleaning member 8. The second offset cleaning position is a position shifted from the reference cleaning position shown in FIG. 4 in a direction toward the second roll cleaning member 8. The central point CP of the wafer W is away from the plane ST and is located between the second roll cleaning member 8 and the plane ST. When the wafer W is sandwiched between the first roll cleaning member 7 and the second roll cleaning member 8 at the second offset cleaning position as shown in FIG. 6, the first surface 1a of the wafer W is held in a concave shape, and the second surface 1b of the wafer W is held in a convex shape. In this specification, scrubbing the wafer W with the first roll cleaning member 7 and the second roll cleaning member 8 at the second offset cleaning position is defined as second offset cleaning operation.

The cleaning apparatus is configured to perform a scrub cleaning operation that includes a combination of the reference cleaning operation, the first offset cleaning operation, and the second offset cleaning operation.

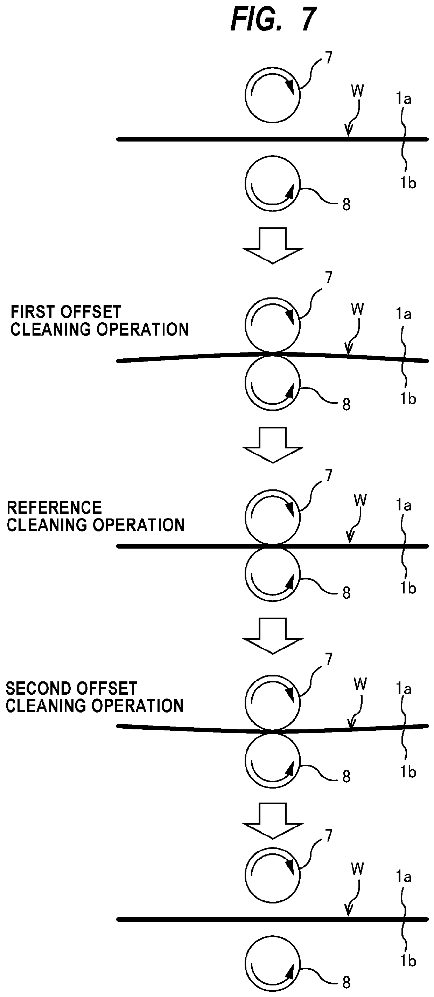

An embodiment of the scrub cleaning operation performed by the cleaning apparatus will be described in detail below. FIG. 7 is a schematic diagram showing an embodiment of the scrub cleaning operation for cleaning a wafer W having a flat shape. In this embodiment, the scrub cleaning operation of the wafer W is performed in the order of the first offset cleaning operation, the reference cleaning operation, and the second offset cleaning operation. In one embodiment, the first offset cleaning operation, the reference cleaning operation, and the second offset cleaning operation may be performed for the same time.

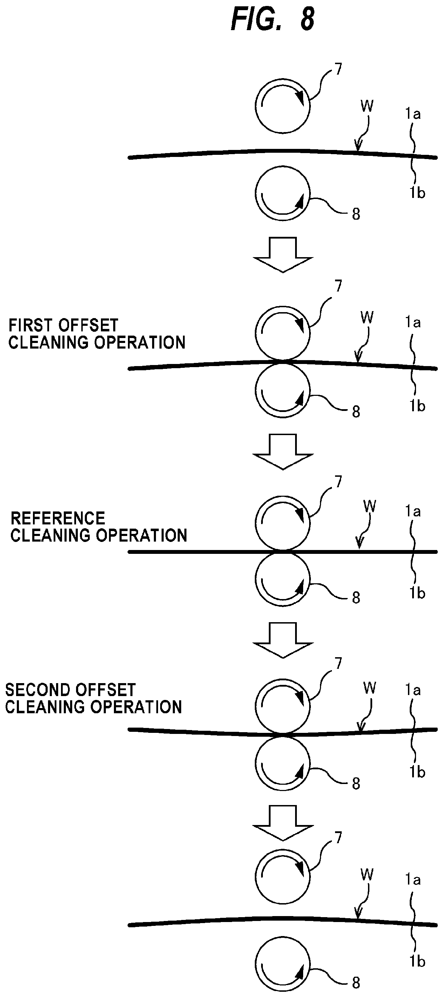

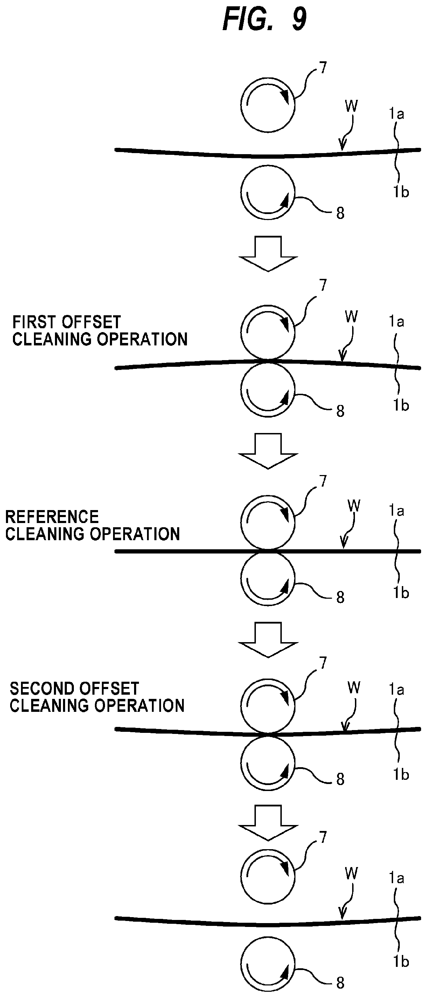

FIG. 8 is a schematic diagram showing an embodiment of a scrub cleaning operation for cleaning a wafer W whose first surface 1a is convex, and FIG. 9 is a schematic diagram showing an embodiment of a scrub cleaning operation for cleaning a wafer W whose first surface 1a is concave. In these embodiments, the scrub cleaning operation of the wafer W is performed in the order of the first offset cleaning operation, the reference cleaning operation, and the second offset cleaning operation. In one embodiment, the first offset cleaning operation, the reference cleaning operation, and the second offset cleaning operation may be performed for the same time.

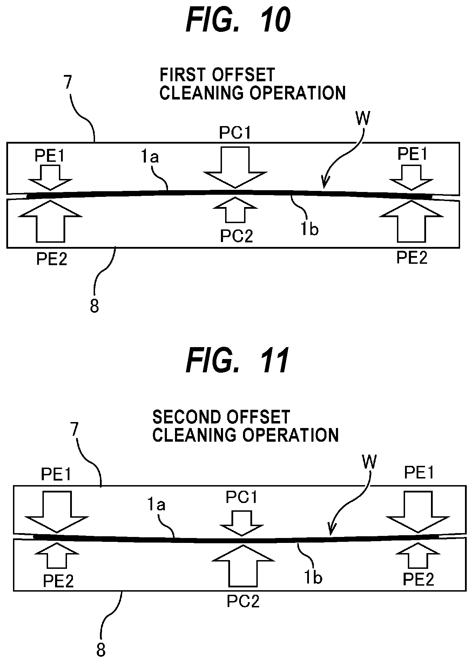

FIG. 10 is a diagram showing a distribution of pressures applied to a wafer W from the first roll cleaning member 7 and the second roll cleaning member 8 during the first offset cleaning operation. As shown in FIG. 10, a pressure PC1 applied from the first roll cleaning member 7 to the center of the first surface 1a of the wafer W is larger than a pressure PE1 applied from the first roll cleaning member 7 to an edge portion of the first surface 1a of the wafer W. On the other hand, a pressure PC2 applied from the second roll cleaning member 8 to the center of the second surface 1b of the wafer W is smaller than a pressure PE2 applied from the second roll cleaning member 8 to an edge portion of the second surface 1b of the wafer W.

FIG. 11 is a diagram showing a distribution of pressures applied to the wafer W from the first roll cleaning member 7 and the second roll cleaning member 8 during the second offset cleaning operation. As shown in FIG. 11, a pressure PC1 applied from the first roll cleaning member 7 to the center of the first surface 1a of the wafer W is smaller than a pressure PE1 applied from the first roll cleaning member 7 to the edge portion of the first surface 1a of the wafer W. On the other hand, a pressure PC2 applied from the second roll cleaning member 8 to the center of the second surface 1b of the wafer W is larger than a pressure PE2 applied from the second roll cleaning member 8 to the edge portion of the second surface 1b of the wafer W.

As can be seen from FIGS. 10 and 11, the distribution of pressures applied to the wafer W from the first roll cleaning member 7 and the second roll cleaning member 8 is different between the first offset cleaning operation and the second offset cleaning operation. Such a difference in pressure distribution occurs in the same way for the wafers W having different shapes as shown in FIGS. 7 to 9. The cleaning apparatus can clean any shape of wafer W with the same cleaning efficiency by generating such a difference in pressure distribution during the scrub cleaning operation of the wafer W (improved reproducibility of cleaning). Specifically, even if the first surface 1a of the wafer W is convex, or the second surface 1b of the wafer W is convex, or the wafer W has a wavy shape, the cleaning apparatus can clean the wafer W with different pressure distributions as shown in FIGS. 10 and 11. As a result, non-uniformity in cleaning caused by the shape of the wafer W can be reduced.

The order of the first offset cleaning operation, the reference cleaning operation, and the second offset cleaning operation is not limited to the above-mentioned embodiment. Examples of the order of the first offset cleaning operation, the reference cleaning operation, and the second offset cleaning operation as follows:
- First offset cleaning operation → Reference cleaning operation → Second offset cleaning operation
- Second offset cleaning operation → Reference cleaning operation → First offset cleaning operation
- Reference cleaning operation → First offset cleaning operation → Second offset cleaning operation
- Reference cleaning operation → Second offset cleaning operation → First offset cleaning operation
- First offset cleaning operation → Second offset cleaning operation → Reference cleaning operation
- Second offset cleaning operation → First offset cleaning operation → Reference cleaning operation

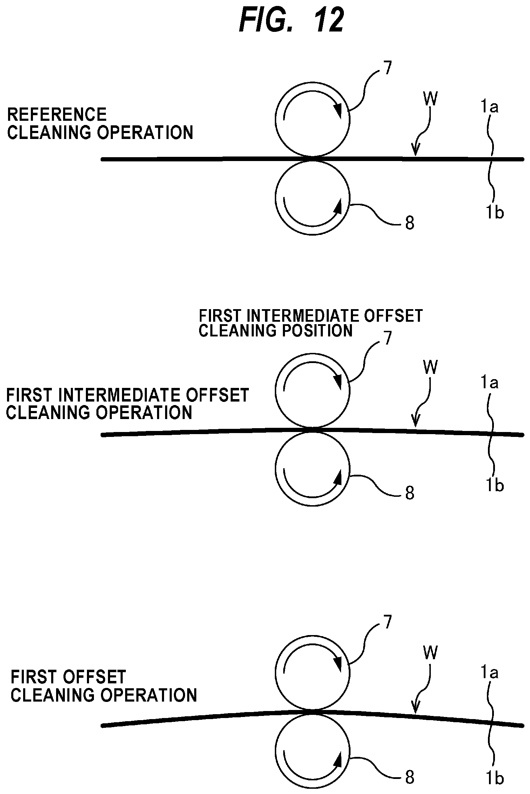

In one embodiment, as shown in FIG. 12, the operation controller 40 is configured to instruct the first actuator 21 and the second actuator 22 to move the first roll cleaning member 7 and the second roll cleaning member 8 to a first intermediate offset position located between the reference cleaning position and the first offset cleaning position. The cleaning apparatus is further configured to perform a first intermediate offset cleaning operation in which the first roll cleaning member 7 and the second roll cleaning member 8 at the first intermediate offset position scrub the first surface 1a and the second surface 1b of the wafer W. In this specification, scrubbing the wafer W with the first roll cleaning member 7 and the second roll cleaning member 8 at the first intermediate offset cleaning position is defined as first intermediate offset cleaning operation.

In one embodiment, the first intermediate offset cleaning operation is performed for the same time as those of the reference cleaning operation, the first offset cleaning operation, and the second offset cleaning operation. The first intermediate offset cleaning operation can create a pressure distribution different from that in the first offset cleaning operation. In particular, the first intermediate offset cleaning operation can increase the pressure at an intermediate portion between the center and the edge portion of the first surface 1a of the wafer W. As a result, the cleaning apparatus can clean wafers W of various shapes with the same cleaning efficiency.

The order of the reference cleaning operation, the first offset cleaning operation, the first intermediate offset cleaning operation, and the second offset cleaning operation is not particularly limited. For example, the first intermediate offset cleaning operation may be performed before the first offset cleaning operation, or may be performed after the first offset cleaning operation.

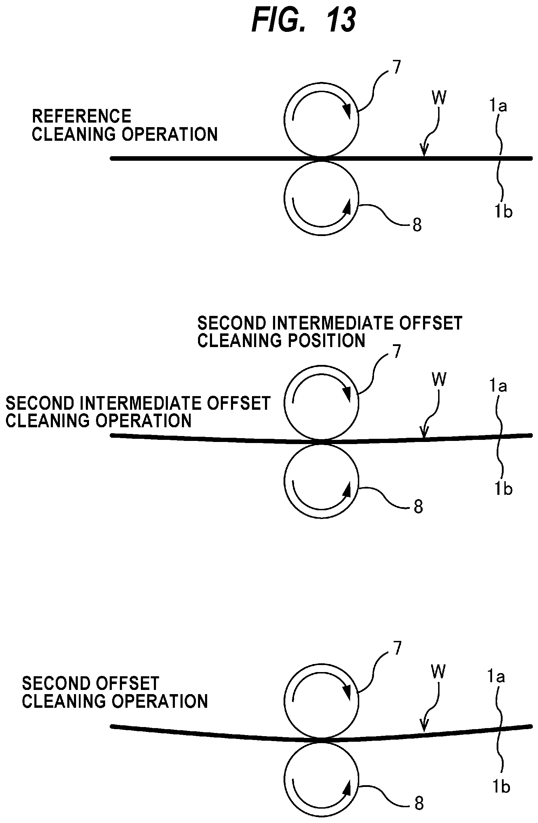

In one embodiment, as shown in FIG. 13, the operation controller 40 is configured to instruct the first actuator 21 and the second actuator 22 to move the first roll cleaning member 7 and the second roll cleaning member 8 to a second intermediate offset position located between the reference cleaning position and the second offset cleaning position. The cleaning apparatus is further configured to perform a second intermediate offset cleaning operation in which the first roll cleaning member 7 and the second roll cleaning member 8 at the second intermediate offset position scrub the first surface 1a and the second surface 1b of the wafer W. In this specification, scrubbing the wafer W with the first roll cleaning member 7 and the second roll cleaning member 8 at the second intermediate offset cleaning position is defined as second intermediate offset cleaning operation.

In one embodiment, the second intermediate offset cleaning operation is performed for the same time as those in the reference cleaning operation, the first offset cleaning operation, and the second offset cleaning operation. The second intermediate offset cleaning operation can create a pressure distribution different from that in the second offset cleaning operation. In particular, the second intermediate offset cleaning operation can increase the pressure at an intermediate portion between the center and the edge of the second surface 1b of the wafer W. As a result, the cleaning apparatus can clean wafers W of various shapes with the same cleaning efficiency.

The order of the reference cleaning operation, the first offset cleaning operation, the second intermediate offset cleaning operation, and the second offset cleaning operation is not particularly limited. For example, the second intermediate offset cleaning operation may be performed before the second offset cleaning operation, or may be performed after the second offset cleaning operation.

In one embodiment, the cleaning apparatus is configured to perform a scrub cleaning operation including a combination of the reference cleaning operation, the first offset cleaning operation, the first intermediate offset cleaning operation, the second offset cleaning operation, and the second intermediate offset cleaning operation. The order of the reference cleaning operation, the first offset cleaning operation, the first intermediate offset cleaning operation, the second offset cleaning operation, and the second intermediate offset cleaning operation is not particularly limited. Examples of the order will be described below, but the order of the scrub cleaning operation is not limited to the following examples.
- First offset cleaning operation → First intermediate offset cleaning operation → Reference cleaning operation → Second intermediate offset cleaning operation → Second offset cleaning operation
- Second offset cleaning operation → Second intermediate offset cleaning operation → Reference cleaning operation → First intermediate offset cleaning operation → First offset cleaning operation
- Reference cleaning operation → First offset cleaning operation → First intermediate offset cleaning operation → Second intermediate offset cleaning operation → Second offset cleaning operation
- Reference cleaning operation → Second offset cleaning operation → Second intermediate offset cleaning operation → First offset cleaning operation
- First intermediate offset cleaning operation → First offset cleaning operation → Second offset cleaning operation → Second intermediate offset cleaning operation → Reference cleaning operation
- Second intermediate offset cleaning operation → Second offset cleaning operation → First offset cleaning operation → First intermediate offset cleaning operation → Reference cleaning operation

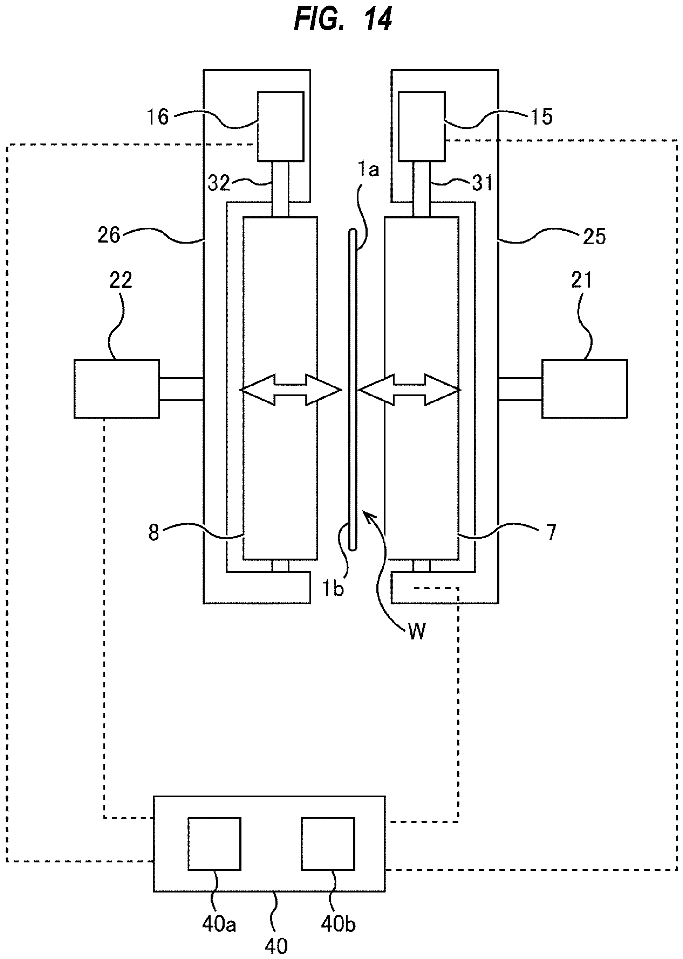

In the embodiments discussed with reference to FIGS. 1 to 13, the wafer W is cleaned in a horizontal posture. In one embodiment, the cleaning apparatus may be configured to clean the wafer W in a vertical posture, as shown in FIG. 14. In another embodiment, the wafer W may be cleaned in an oblique posture, not shown.

The previous description of embodiments is provided to enable a person skilled in the art to make and use the present invention. Moreover, various modifications to these embodiments will be readily apparent to those skilled in the art, and the generic principles and specific examples defined herein may be applied to other embodiments. Therefore, the present invention is not intended to be limited to the embodiments described herein but is to be accorded the widest scope as defined by limitation of the claims.

## Claims

1. A cleaning method of cleaning a wafer, comprising:
performing a scrub cleaning operation of scrubbing a first surface and a second surface of the wafer with a first roll cleaning member and a second roll cleaning member, respectively, while rotating the wafer about a central axis with a plurality of holding rollers contacting a periphery of the wafer,
the scrub cleaning operation including:
a reference cleaning operation of scrubbing the first surface and the second surface of the wafer with the first roll cleaning member and the second roll cleaning member located at a reference cleaning position;
a first offset cleaning operation of scrubbing the first surface and the second surface of the wafer with the first roll cleaning member and the second roll cleaning member located at a first offset cleaning position shifted from the reference cleaning position in a direction toward the first roll cleaning member; and
a second offset cleaning operation of scrubbing the first surface and the second surface of the wafer with the first roll cleaning member and the second roll cleaning member located at a second offset cleaning position shifted from the reference cleaning position in a direction toward the second roll cleaning member.

2. The cleaning method according to claim 1, wherein the reference cleaning operation, the first offset cleaning operation, and the second offset cleaning operation are performed in a predetermined order.

3. The cleaning method according to claim 1, wherein the scrub cleaning operation further includes a first intermediate offset cleaning operation of scrubbing the first surface and the second surface of the wafer with the first roll cleaning member and the second roll cleaning member located at a first intermediate offset position, and
the first intermediate offset position is located between the reference cleaning position and the first offset cleaning position.

4. The cleaning method according to claim 1, wherein the scrub cleaning operation further includes a second intermediate offset cleaning operation of scrubbing the first surface and the second surface of the wafer with the first roll cleaning member and the second roll cleaning member located at a second intermediate offset position, and
the second intermediate offset position is located between the reference cleaning position and the second offset cleaning position.

5. A cleaning apparatus for cleaning a wafer, comprising:
a plurality of holding rollers which are rotatable and are configured to contact a periphery of the wafer and rotate the wafer about a central axis;
a first roll cleaning member and a second roll cleaning member configured to scrub a first surface and a second surface of the wafer, respectively;
a first actuator coupled to the first roll cleaning member and configured to move the first roll cleaning member;
a second actuator coupled to the second roll cleaning member and configured to move the second roll cleaning member; and
an operation controller configured to control operations of the first actuator and the second actuator,
wherein the operation controller is configured to instruct the first actuator and the second actuator to move the first roll cleaning member and the second roll cleaning member to a reference cleaning position, a first offset cleaning position, and a second offset cleaning position,
the cleaning apparatus is configured to perform a scrub cleaning operation including a combination of:
a reference cleaning operation of scrubbing the first surface and the second surface of the wafer with the first roll cleaning member and the second roll cleaning member located at the reference cleaning position;
a first offset cleaning operation of scrubbing the first surface and the second surface of the wafer with the first roll cleaning member and the second roll cleaning member located at the first offset cleaning position shifted from the reference cleaning position in a direction toward the first roll cleaning member; and
a second offset cleaning operation of scrubbing the first surface and the second surface of the wafer with the first roll cleaning member and the second roll cleaning member located at the second offset cleaning position shifted from the reference cleaning position in a direction toward the second roll cleaning member.

6. The cleaning apparatus according to claim 5, wherein the operation controller is configured to instruct the first actuator and the second actuator to move the first roll cleaning member and the second roll cleaning member to the reference cleaning position, the first offset cleaning position, and the second offset cleaning position in a predetermined order.

7. The cleaning apparatus according to claim 5, wherein the operation controller is configured to instruct the first actuator and the second actuator to move the first roll cleaning member and the second roll cleaning member to a first intermediate offset position located between the reference cleaning position and the first offset cleaning position, and
the cleaning apparatus is further configured to perform a first intermediate offset cleaning operation of scrubbing the first surface and the second surface of the wafer with the first roll cleaning member and the second roll cleaning member located at the first intermediate offset position.

8. The cleaning apparatus according to claim 5, wherein the operation controller is configured to instruct the first actuator and the second actuator to move the first roll cleaning member and the second roll cleaning member to a second intermediate offset position located between the reference cleaning position and the second offset cleaning position, and
the cleaning apparatus is further configured to perform a second intermediate offset cleaning operation of scrubbing the first surface and the second surface of the wafer with the first roll cleaning member and the second roll cleaning member located at the second intermediate offset position.
